# EUROPEAN PATENT APPLICATION

(11) **EP 1 353 371 A1**
(43) Date of publication of application: **15.10.2003**
(21) Application number: 02425225.6
(22) Date of filing: 12.04.2002
(51) Int. Cl.: H01L 21/8246, H01L 27/112

(54) **Two-bit rom cell manufacturing process**

(71) Applicant: STMicroelectronics S.r.l., 20041 Agrate Brianza (Milano) (IT)
(72) Inventor: Riva, Marco, 24040 Lallio (BG) (IT)
(74) Representative: Maccalli, Marco

(57) **Abstract**

A process for fabricating a two-bit ROM cell, comprises forming a control electrode (**1052n,1053n**) over a semiconductor layer (**103**) of a first conductivity type, a region of the semiconductor layer underlying the control electrode constituting a memory cell channel region; and providing, on either side of the channel region, differentiated-resistance doped regions (**1151-1154;2011-2014,2031-2034**) having respective resistance values that depends on a logic state of a respective one of the two bits to be stored in the cell, the resistance values of the differentiated-resistance doped regions being set by means of a selective introduction of dopants. The differentiated-resistance doped regions are formed by selectively providing sidewall spacers (**109**) at sidewalls of the control electrode, and using the sidewall spacers as a mask against the introduction of dopants.

## Description

The present invention relates generally to the field of semiconductor memories, and particularly to non-volatile memories. Specifically, the invention concerns two-bit read only memory ("ROM") cells.

Semiconductor ROMs have memory cells formed by a simple MOSFET. During the manufacturing of the memory, dopants of a prescribed conductivity type are selectively implanted, by means of a mask, into selected areas of a semiconductor substrate, corresponding to the channel regions of the memory cells. The implanted dopants cause a shift in the threshold voltage of those memory cells whose channel regions are implanted, compared to the memory cells whose channel regions are instead not implanted. The different threshold voltage values, detectable by biasing the memory cells in prescribed conditions and sensing the absorbed currents, are associated to the two opposite logic states ("1" and "0"), so that the memory cells are capable of storing one bit.

In the attempt of increasing the memory storage capacity per unit semiconductor area, semiconductor ROMs have been proposed wherein each memory cell is capable of storing two bits, instead of just one bit.

One such two-bit ROM cell is described in US 6,201,282. The two bits are separately stored in two different areas at the two sides of the cell's channel region, located between the channel region and the source/drain regions of the memory cell. A programmed bit has a threshold pocket implant formed in the respective area, while a non-programmed bit has no such implant.

That document also describes a process for the manufacturing of an array of two-bit ROM cells. A bit line mask of photoresist or oxide is formed, comprising a plurality of strips. Arsenic ions are then implanted to form the bit line diffusions. Two distinct programming masks are applied in succession to the structure, and two respective implants of boron are performed, along oppositely tilted directions with respect to a perpendicular to the top surface of the structure. The boron implants form, where required, the pocket implants for programming the desired logic states in the memory cells. Then, the bit line mask is removed, a gate oxide for the memory cells is formed, and polysilicon word lines are defined.

It can be appreciated that the process described above requires two distinct masks, and two distinct tilted implants of dopants. This clearly makes the fabrication process of a two-bit ROM cell more complicated compared to a process for fabricating a single-bit ROM cell. The necessity of two distinct programming masks stems from the fact that, in consideration of the compactness of the memory cell array, if a single programming mask were used, shadow effects created by the programming mask itself could prevent the dopants from being implanted where desired.

In view of the state of the art outlined, it has been an object of the present invention to provide a process for manufacturing a two-bit ROM cell overcoming the above-discussed problems.

In particular, it has been an object of the present invention to provide a manufacturing process requiring less masks for programming the memory cells.

According to the present invention, these and other objects has been attained by means of a process as set forth in claim 1, comprising:
forming a control electrode over a semiconductor layer of a first conductivity type, a region of the semiconductor layer underlying the control electrode constituting a memory cell channel region;
providing, on either side of the channel region, differentiated-resistance doped regions having respective resistance values that depends on a logic state of a respective one of the two bits to be stored in the cell, the differentiated-resistance doped regions resistance values being set by means of a selective introduction of dopants,
characterised in that said providing the differentiated-resistance doped regions comprises:
selectively providing sidewall spacers at sidewalls of the control electrode, and
using the sidewall spacers as a mask against the introduction of dopants.

The features and advantages of the present invention will be made apparent by the following detailed description of some embodiments thereof, provided merely by way of non-limitative examples and illustrate in the annexed drawings, wherein:
**FIGS. 1A** to **1M** show, in schematic cross-sectional views, a portion of an array of two-bit ROM cells during the main steps of a manufacturing process according to a first embodiment of the present invention;
**FIG. 1N** is a schematic top-plan view of the portion of array of two-bit ROM cells after the step of **FIG. 1F**;
**FIG. 1P** is a schematic top-plan view of the portion of array of two-bit ROM cells at the step of **FIG. 1I**;
**FIG. 1Q** is an enlarged cross-sectional view of a two-bit ROM cell of the array;
**FIGS. 2A** to **2F** show, in schematic cross-sectional views, a portion of an array of two-bit ROM cells during the main steps of a manufacturing process according to a second embodiment of the present invention;
**FIG. 2G** is an enlarged cross-sectional view of a two-bit ROM cell of the array, according to the second embodiment of the invention;
**FIGS. 3A** to **3C** show a variant of the process shown in **FIGS. 1A** to **1M.**

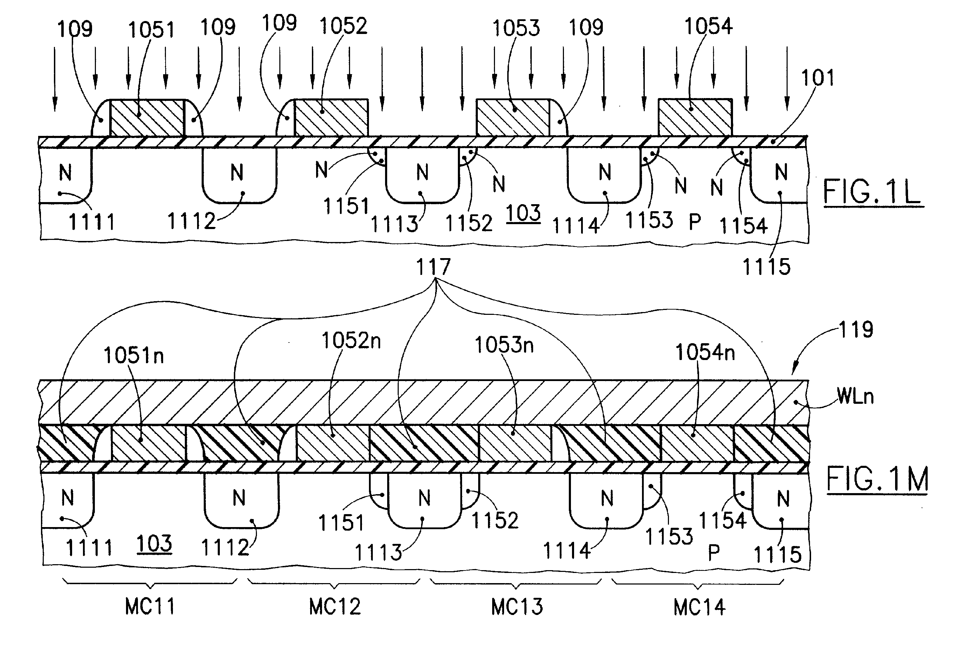

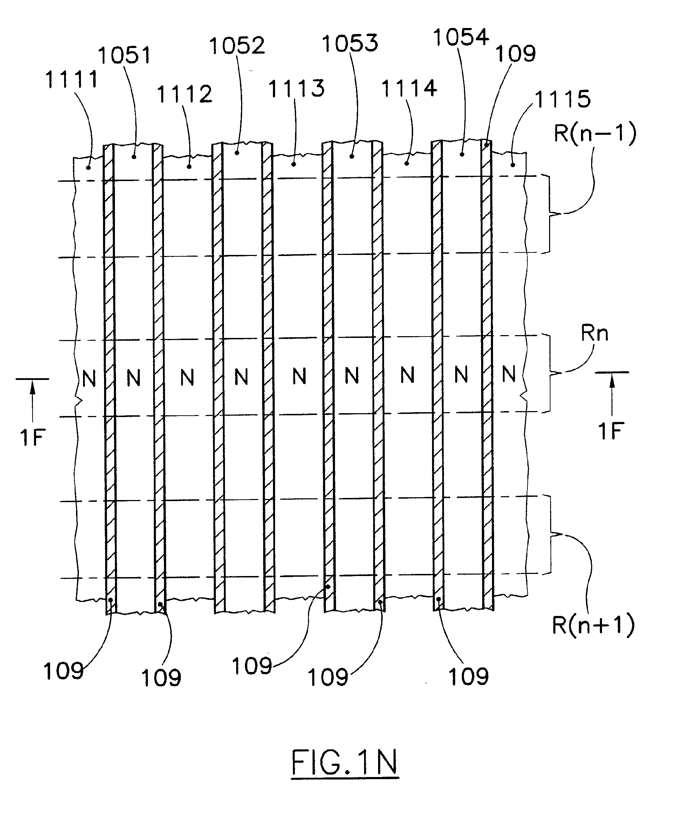

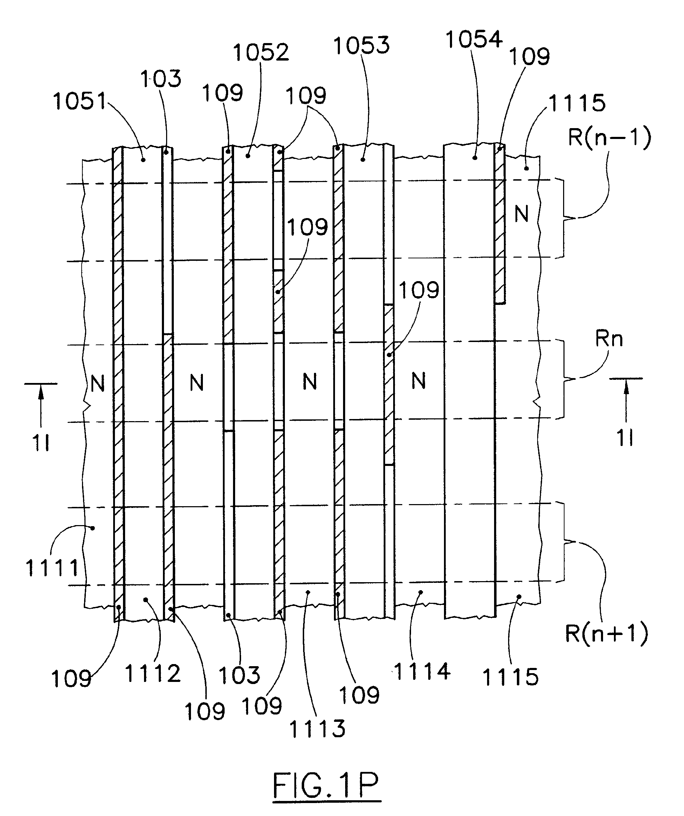

In **FIGS. 1A** to **1M** the main steps of a manufacturing process according to a first embodiment of the present invention are shown. In particular, these drawings are simplified cross-sectional views of a portion of an array of two-bit ROM cells, taken along a generic row of the array. Even more particularly, **FIGS. 1A** to **1M** show a portion of a row **Rn** (**FIG. 1N**) of an array of the so-called contactless or "virtual ground" type, wherein the array bit lines are represented by elongated doped regions; the row portion shown in the drawings includes four two-bit ROM cells.

Referring to **FIG. 1A,** a dielectric layer **101,** for example of silicon dioxide (SiO₂), is formed on a top surface of a semiconductor layer **103** in a region thereof intended to accommodate the array of memory cells. The semiconductor layer **103** is for example of the P conductivity type with a doping level ranging from 10¹⁵ to 10¹⁸ atoms/cm³. The silicon dioxide layer **101** can be formed by thermal oxidation or by chemical vapor deposition (CVD). The silicon dioxide layer **101** will form the gate oxide of the two-bit ROM cells and has for example a thickness of 50 - 150 Å.

The semiconductor layer **103** can be the substrate of a semiconductor wafer, or a doped semiconductor well formed in the wafer substrate.

As shown in **FIG. 1B**, a conductive layer **105**, for example of polysilicon, is formed on the silicon dioxide layer **101**. The polysilicon layer **105** is for example formed by deposition.

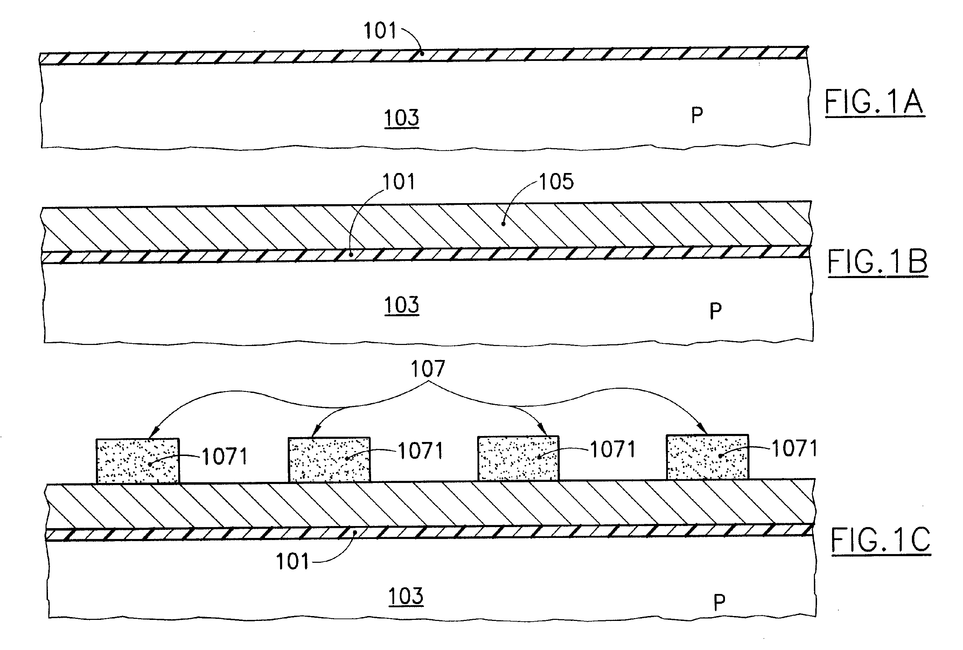

Passing to **FIG. 1C,** a photoresist layer **107** is then deposited on the polysilicon layer **105**; according to conventional photolithographic techniques, the photoresist layer **107** is exposed to a suitable radiation source (*e.g*., UV rays) through a mask (not shown), then the photoresist layer **107** is developed and selectively removed. Portions **1071** of the photoresist layer **107** are thus left on the polysilicon layer **105** in correspondence of areas thereof intended to form gate electrodes of the memory cells.

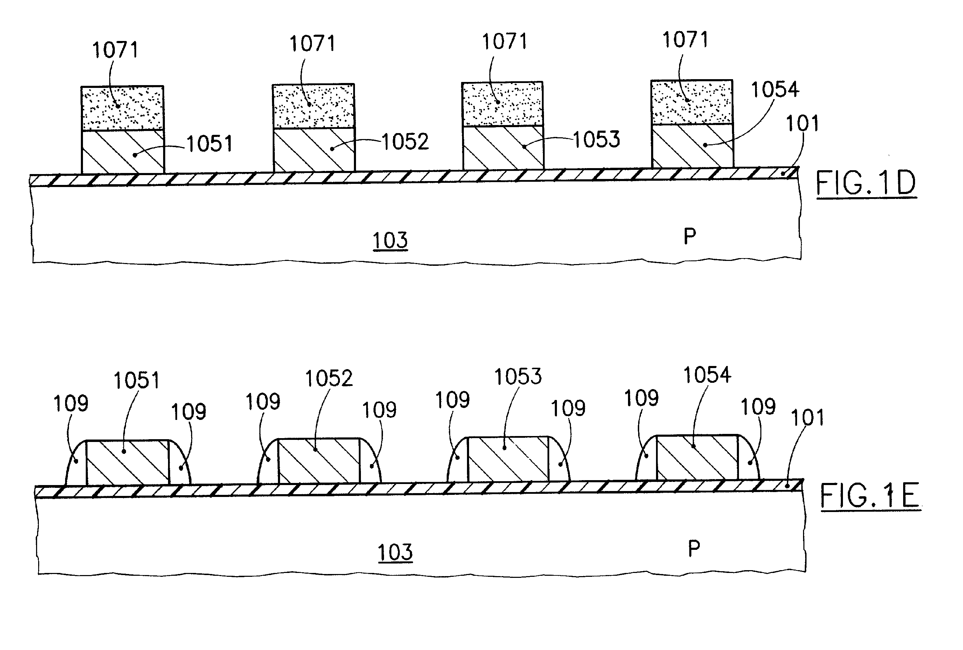

Reference is now made to **FIG. 1D**: using the photoresist layer portions **1071** as a protective mask, the polysilicon layer **105** is then selectively removed from over the silicon dioxide layer **101** by means of a selective etch process. Portions **1051** - **1054** of the polysilicon layer **105** are thus left from which the gate electrodes of the memory cells will be obtained. In particular, as visible in **FIG. 1N**, the polysilicon layer portions **1051** - **1054** are elongated strips extending substantially parallelly to each other and transversally, typically orthogonally, to the rows **R(n-1)**, **Rn, R(n+1)** of the array of memory cells.

As shown in **FIGS. 1E** and **1N,** the portions **1071** of the photoresist layer are then removed, and sidewall spacers **109** are formed at the side walls of the polysilicon layer portions **1051** - **1054**, *i.e*. at the sides of the gate electrodes of the memory cells. The spacers **109** are for example obtained by forming on the top surface of the structure a layer of silicon dioxide, and then submitting the silicon dioxide layer to an anisotropic etch process.

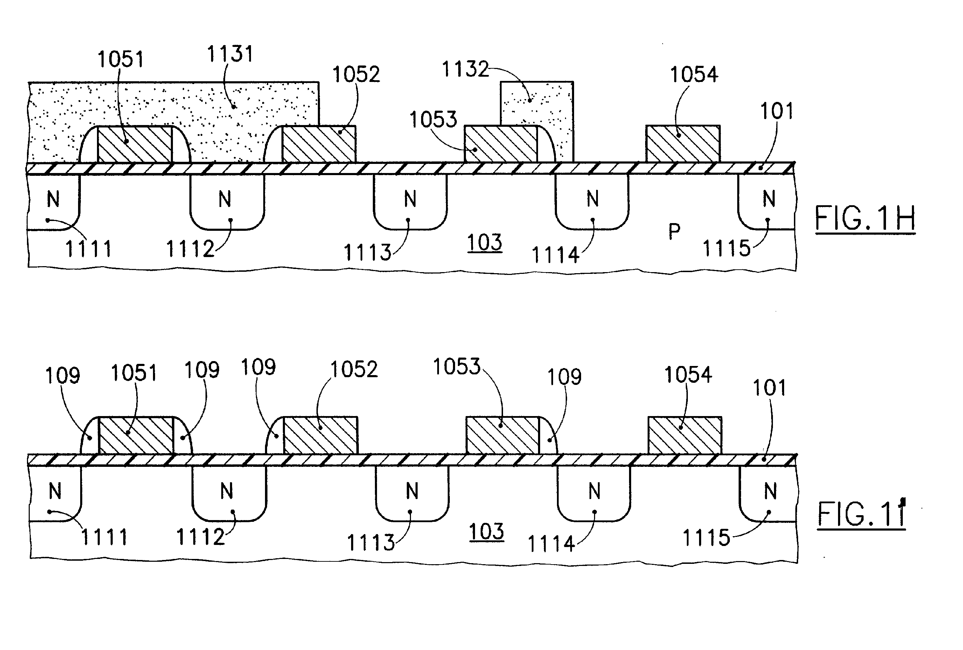

Passing to **FIG. 1F,** dopants of the N type are then implanted into regions of the semiconductor layer **103** not covered by the polysilicon layer portions **1051** - **1054** and the spacers **109.** As visible in **FIG. 1N,** N type elongated regions **1111** - **1115** are thus formed in the P type semiconductor layer **103** in self-alignment with the spacers **109**. The N type elongated regions **1111** - **1115** form source/drain regions of the memory cells. The dopants are for example arsenic ions, implanted in a dose of the order of 10¹⁵ atoms/cm², with an energy such to prevent dopants from being implanted under the polysilicon layer portions **1051** - **1054** and the spacers **109**. In particular, it is important that the N type regions **1111** - **1115** are adequately spaced-apart from the sidewalls of the polysilicon layer portions **1051** - **1054**.

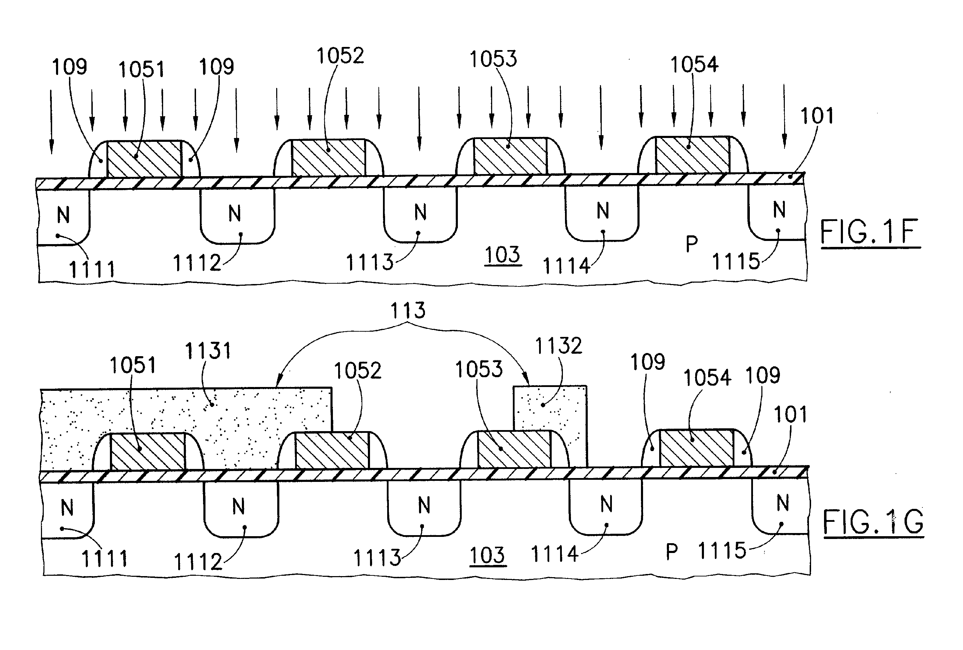

Referring to **FIG. 1G,** a programming mask is then formed on the array area. To form the programming mask, a photoresist layer **113** is formed over the whole structure, particularly over the whole array area. The photoresist layer **113** is then exposed to a suitable radiation source (*e.g.*, UV rays) through a mask (not shown), and is then developed and selectively removed. Portions **1131** and **1132** of the photoresist layer **113** are thus left. The portions of the photoresist layer that are left cover the spacers **109**, or portions thereof, that are not to be removed. In the shown example, a photoresist layer portion **1131** covers the sidewall spacers **109** at the sides of the polysilicon layer portion **1051,** and the spacer **109** at the left-hand side of the polysilicon layer portion **1052**; the photoresist layer portion **1132** covers the spacer **109** at the right-hand side of the polysilicon layer portion **1053**; the spacer at the right-hand side of the polysilicon layer portion **1052**, the spacer at the left-hand side of the polysilicon layer portion **1053** and the two spacers at both sides of the polysilicon layer portion **1054** are left uncovered.

As shown in **FIG. 1H**, a selective etch process is performed to remove the spacers **109** not protected by the programming mask, *i*.*e*. by the photoresist layer portions **1131** and **1132.** In particular, an anisotropic etch process, such as a plasma etch or, preferably, an isotropic etch process, such as a wet etch, is performed.

Referring to **FIGS. 1I** and **1P**, the photoresist layer **113** is then completely removed. As shown in **FIG. 1L**, N type dopants are then implanted. Where the spacers **109** have been removed, such as at the right-hand side of the polysilicon layer portion **1052,** at the left-hand side of the polysilicon layer portion **1053** and at both sides of the polysilicon layer portion **1054**, the surface of the P type semiconductor layer **103** is exposed and the implanted dopants form N type regions **1151**, **1152**, **1153** and **1154**, having a relatively low resistance, extending from the edge of the adjacent N type region **1113, 1114** and **1115** to the edge of the polysilicon layer portion **1052, 1053** and **1054**. The dopant can be for example arsenic, and is implanted in a dose sufficiently high to cause the regions **1151, 1152, 1153** and **1154** have a low resistance; suitable doses may range for example from 10¹² to 10¹⁴ ions/cm².

Where present, the N type regions **1151, 1152, 1153** and **1154** allow the conductive channel, which is established in the channel region of the respective memory cell (*i*.*e*. under the gate electrode **1052, 1053** and **1054**) under prescribed bias conditions, to be electrically connected to the adjacent source/drain region **1113, 1114, 1115.** Where instead the N type regions **1151, 1152, 1153, 1154** are not present, the memory cells' channel is electrically disconnected from the adjacent source/drain region by the P type semiconductor layer **103** (which introduces a very high resistance between the memory cell's channel and the adjacent source/drain region).

If desired, after this step the remaining spacers **109** can be completely removed, or they can be left, as in the shown example.

Then, a relatively thick dielectric layer **117,** such as silicon dioxide, is deposited over the array area. The dielectric layer **117** is then preferably planarised, for example by means of a chemical-mechanical polishing (CMP), and it is then submitted to an etch process, for example a plasma etch. The thickness of the dielectric layer **117** is progressively reduced until the surface polysilicon layer portions **1051** - **1054** are exposed; portions of the dielectric layer **117** are thus left only in between the polysilicon layer portions **1051** - **1054**, flush therewith.. A conductive layer **119**, for example of polysilicon, is then formed on the dielectric layer **117**. By conventional photolithographic techniques, the polysilicon layer **119** is patterned to form word lines of the array, such as the word line **WLn** shown in **FIG. 1M.** During the definition of the word lines, also the underlying polysilicon layer portions **1051** - **1054** are selectively etched and removed in between the rows **R(n-1), Rn, R(n+1)** of the array, thereby forming distinct polysilicon layer segments along each row of the array, such as the polysilicon layer segments **1051n, 1052n, 1053n, 1054n** shown in **FIG. 1M** along the row **Rn.** Each polysilicon layer segment forms the gate electrode of a respective memory cell of the array. The array word lines, one for each array row, contacts the underlying polysilicon layer segments, *i.e*. the gate electrodes of the memory cells. A conventional row selector, not shown in the drawings, allows driving the word line potentials.

The N type regions **1111** - **1115** are contacted, outside of the array, by conductive lines, typically in aluminium, routed to a conventional sensing circuitry through a bit line selector (not shown in the drawings).

The operation of a two-bit ROM cell obtained by means of the manufacturing process described in the foregoing will be now explained.

Each one of the memory cells **MC11** - **MC14** stores two bits. Each one of the two bits is stored in a respective one of the two memory cell's bit storage regions comprised between the memory cell's channel region and the source/drain regions **1111, 1112, 1113, 1114, 1115.** The logic state of the bit depends on the presence or the absence, in the respective bit storage region, of a low-resistance region such as the N type regions **1151, 1152, 1153, 1154**. Conventionally, the absence of the low-resistance regions is associated with a "0" logic state, while the presence of such a region is associated with a "1" logic state. In the shown example, the memory cell **MC11** stores a "00", the memory cell **MC11** stores a "01", the memory cell **MC13** stores a "10" and the memory cell **MC14** stores a "11". The opposite convention can of course be adopted.

In a two-bit ROM cell, the source/drain regions change their roles of source electrode or drain electrode depending on which one of the two bits is to be read.

Let for example the memory cell **MC12** be considered, shown in enlarged view in **FIG. 1Q,** and let also be assumed that the right-hand bit of this memory cell is to be read. The word line **WLn** to which the memory cell belong is selected, and the potential thereof raised to a positive voltage **V1,** *e.g.* 3 V. This causes the formation of an inversion layer **121** of the N conductivity type in the region of the P type semiconductor layer **103** under the gate electrode **1052n** of the memory cell (the memory cell's channel region). In order to read the right-hand bit, the adjacent source/drain region **1113** acts as a source electrode, while the opposite source/drain region **1112** acts as a drain electrode. A ground voltage **V2** is applied to the source/drain region **1113,** while the opposite source/drain region **1112** is applied a sufficiently high positive voltage **V3.** The positive voltage **V3** applied to the source/drain region **1112** causes a depletion region **123**, associated with the PN junction formed by the N type region **1112** and the P type layer **103**, to extend laterally to the channel region **121.** The depletion region **123** makes the source/drain region **1112** to be electrically connected to the inversion layer **121**, irrespective of the absence of a low-resistance N region under the left-hand spacer **109**. The ground voltage **V2** applied to the source/drain region **1113** causes a depletion region **125**, associated with the PN junction formed by the N type region **1113** and the P type layer **103**, to have a limited lateral extension and not to reach the inversion layer **121**. The electrical connection of the source/drain region **1113** to the inversion layer **121** thus depends on the presence of a low-resistance N type region between the N type region **1113** and the memory cell's channel region. In the case of the memory cell **MC12**, the presence of the low-resistance N type region **1151** causes the source/drain region **1113** to be electrically connected to the inversion layer **121**; a current thus flows across the memory cell's channel, and the state of the right-hand bit of the memory cell **MC12** is thus detected to be a logic "1".

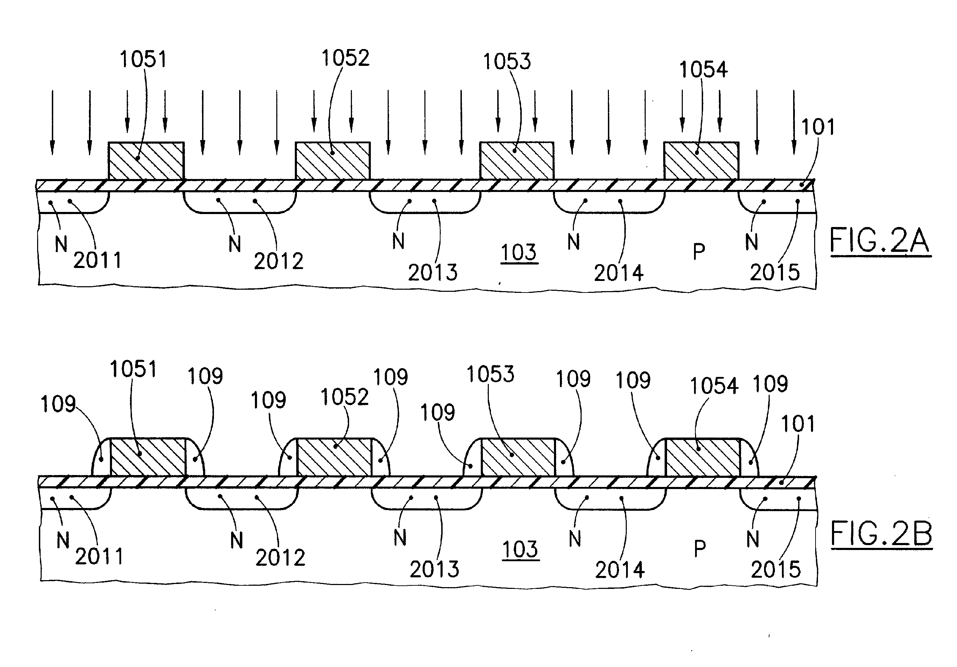

**FIGS. 2A** to **2F** show the main steps of a manufacturing process according to a second embodiment of the present invention. In the drawings, same reference numerals are adopted to identify identical elements in the two embodiments.

The process steps up to the definition of the polysilicon layer portions **1051** - **1054** are the same as in the first embodiment of the process. Also in this case, the polysilicon layer portions **1051** - **1054** are strips extending orthogonally to the array rows.

Referring to **FIG. 2A**, using the polysilicon layer portions **1051** - **1054** as a mask, N type dopants are implanted into the P type semiconductor layer **103**. N type regions **2011, 2012, 2013, 2014** and **2015** are thus formed in between the polysilicon layer portions **1051** - **1054**, in self-alignment thereto. The dopants are for example arsenic ions, and the implant dose is relatively light, for example 10¹² to 10¹⁴ ions/cm².

Passing to **FIG. 2B,** the sidewall spacers **109** are then formed at the side walls of the polysilicon layer portions **1051** - **1054**.

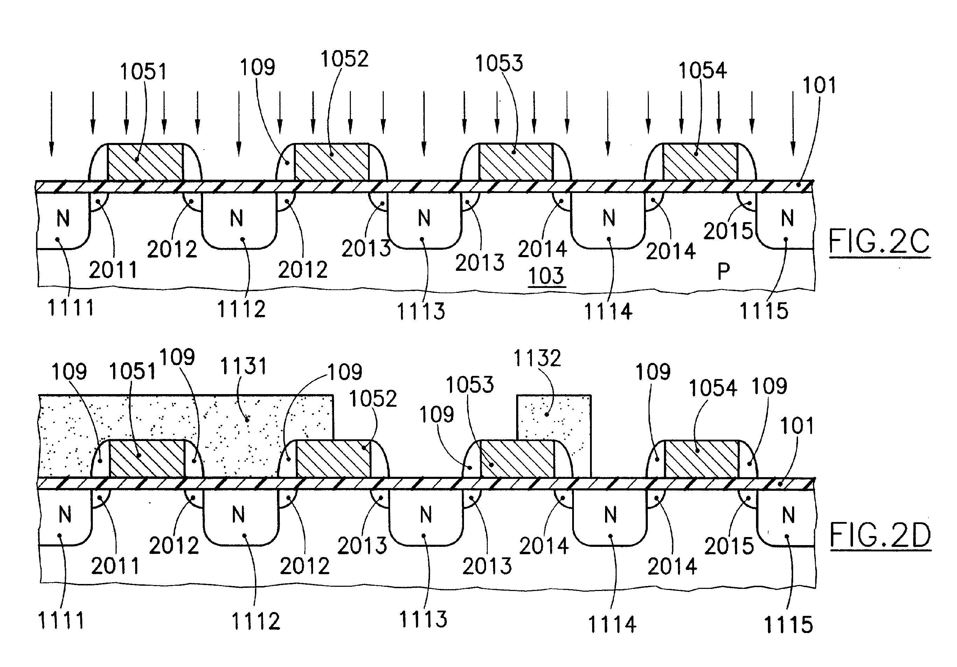

Subsequently, as shown in **FIG. 2C**, N type dopants are then implanted into the P type layer **103** to form the N type elongated regions **1111** - **1115** self-aligned with the spacers **109**. Portions of the N type regions **2011** - **2015** remain at each side of the N type elongated regions **1111** - **1115**, under the spacers **109**.

Making reference to **FIGS. 2D** and **2E**, the programming mask **1131, 1132** is then formed and the spacers 109 are selectively removed, as in the first embodiment previously described.

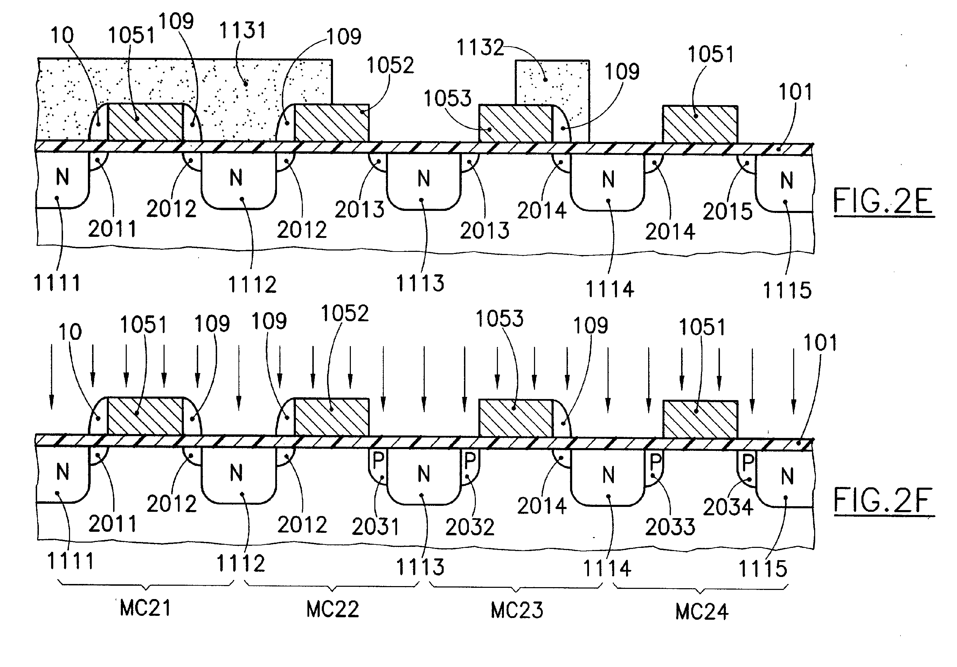

As shown in **FIG. 2F,** the programming mask is then removed, and P type dopants, for example boron ions, are implanted in a dose sufficient to compensate and, preferably, revert the N type doping of the regions **2013**, **2014, 2015,** where the latter are no more covered by the spacer **109.** For example, an implant dose ranging from 10¹² to 10¹⁴ ions/cm² is suitable. P type regions **2031, 2032, 2033, 2034** are thus formed where the uncovered N type regions **2013, 2014, 2015** were present. It is to be observed that a similar result is achieved if the regions **2031**, **2032**, **2033**, **2034** are of the N conductivity type instead of the P conductivity type, but the resistivity thereof is sufficiently high.

The process goes on similarly to the first embodiment previously described, with the optional removal of the remaining spacers, the deposition and etch of the dielectric layer, the deposition and patterning of the word lines and the definition of the memory cells' gate electrodes.

Each one of the memory cells **MC21** - **MC24** stores two bits. Each one of the two bits is stored in a respective one of the two memory cell's bit storage regions comprised between the memory cell's channel region and the source/drain regions **1111, 1112, 1113, 1114, 1115.** The logic state of the bit depends on the presence, in the respective bit storage region, of a low-resistance regions such as the N type regions **2011, 2012, 2033, 2034** or of a P type region such as the P type regions **2031**, **2032**, **2033**. Conventionally, the presence of a P type region is associated with a "0" logic state, while the presence of an N type region is associated with a "1" logic state. In the shown example, the memory cell **MC21** stores a "11", the memory cell **MC22** stores a "10", the memory cell **MC23** stores a "01" and the memory cell **MC24** stores a "00". The opposite convention can of course be adopted.

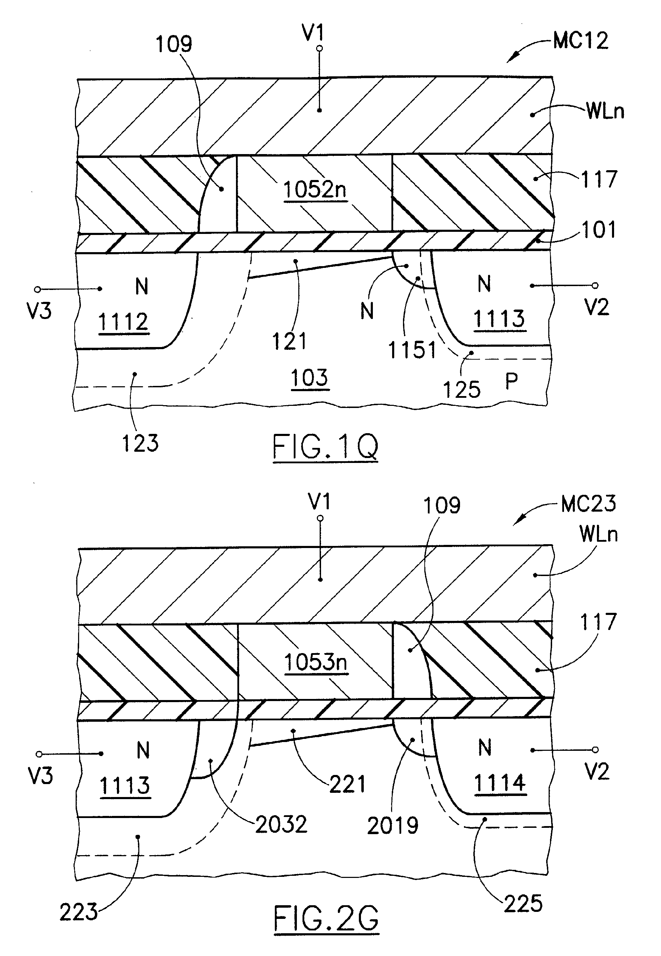

Focusing for example on the memory cell **MC23**, shown in enlarged view in **FIG. 2G**, and assuming that the right-hand bit of this memory cell is to be read, the word line **WLn** to which the memory cell belong is selected, and the potential thereof raised to the positive voltage **V1.** This causes the formation of an inversion layer **221** of the N conductivity type in the region of the P type semiconductor layer **103** under the gate electrode **1053n** of the memory cell (the memory cell's channel region). The adjacent source/drain region **1113** acts as a drain electrode, while the opposite source/drain region **1114** acts as a source electrode. The ground voltage **V2** is applied to the source/drain region **1114,** while the opposite source/drain region **1113** is applied the positive voltage **V3.** The positive voltage **V3** applied to the source/drain region **1112** causes a depletion region **223,** associated with the PN junction formed by the N type region **1113** and the P type layer **103**, to extend laterally to the channel region **221**. The depletion region **223** makes the source/drain region **1113** to be electrically connected to the inversion layer **221**, irrespective of the presence of the P type region **2032,** which is bypassed. The ground voltage **V2** applied to the source/drain region **1114** causes a depletion region **225**, associated with the PN junction formed by the N type region **1114** and the P type layer **103**, to have a limited lateral extension and not to reach the inversion layer **221**. The electrical connection of the source/drain region **1114** to the inversion layer **221** thus depends on the presence of the low-resistance N type region **2014** between the N type region **1114** and the memory cell's channel region. A current thus flows across the memory cell's channel, and the state of the right-hand bit of the memory cell **MC23** is thus detected to be a logic "1".

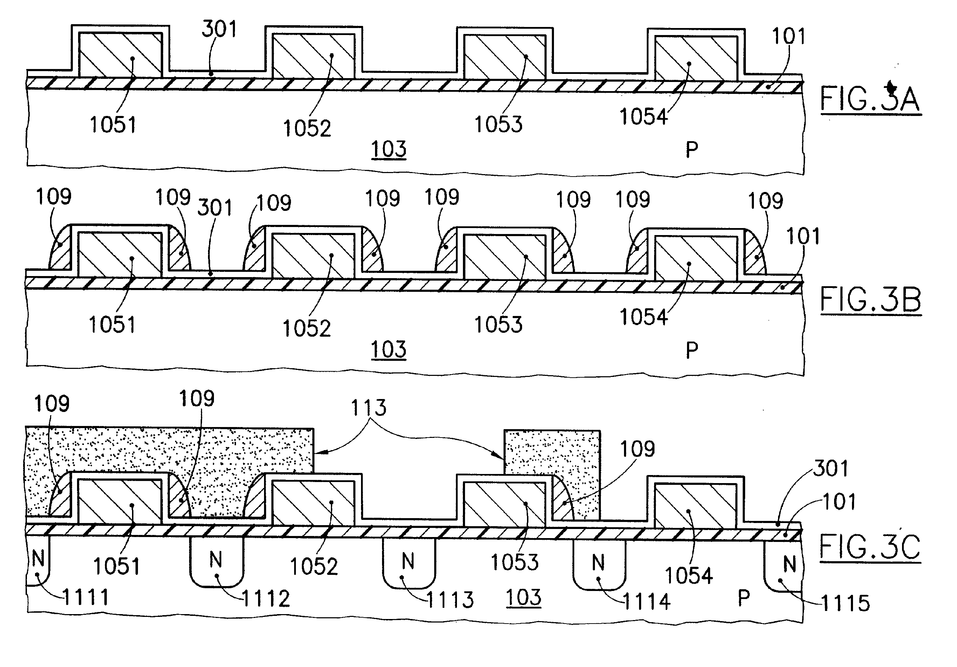

In the two process embodiments described, the spacer material must be such as to allow a selective removal of the spacers without affecting the polysilicon layer. For example, silicon dioxide and silicon nitride have this characteristic. Another embodiment of the invention will be now described which allow to use any spacer materials, even polysilicon. Such other embodiment will be described, making reference to FIGS. **3A** to **3C**, as a variant of the first embodiment described, although the technique could as well be applied to the second process embodiment.

Referring to **FIG. 3A**, after having defined the polysilicon layer portions **1051** - **1054** as in **FIGS. 1C** and **1D,** a liner layer **301** is formed over the structure top surface. The liner layer **301** is for example a layer of silicon nitride. Then, the spacers **109** are formed, as in **FIG. 1E.** The spacers can be of any suitable material, for example polysilicon. Afterwards, as shown in **FIG. 3C**, the mask **113** is applied and the spacers **109** selectively removed. The presence of the liner layer **301** protects the polysilicon layer portions **1051** - **1054**, which are thus not etched even if the etch process, *per se*, is designed to etch polysilicon.

The process goes on as previously described; during the etch of the dielectric layer **117**, the liner **301** is removed to allow the word lines contacting the gate electrodes of the memory cells.

The use of silicon nitride as a liner layer is not limitative: other materials can be used, provided they allow to protect the polysilicon layer portions during the etches that defines and selectively removes the spacers.

It can be appreciated that in the process embodiments described in the foregoing, only one program mask is required for selectively removing the spacers where dopants are to be implanted for modifying the resistance of the regions aside the memory cells' channel regions.

In the process embodiments described, the dopant implants for programming the memory cells are orthogonal to the top surface of the array. This is not to be intended as a limitation of the present invention: the dopants may as well be implanted along tilted directions with respect to the perpendicular to the array top surface; in this case, two implants, instead of a single one, are necessary for programming the memory cells. It is to be observed that the spacers, being flush with the polysilicon layer portions defining the memory cells' gate electrodes, do not shadow the dopant implant in adjacent memory cells. Also in this case, a single programming mask is therefore required, instead of the two programming masks as in the prior art process.

The use of sidewall spacers as masking elements is advantageous because the conventional process of formation of the spacers allows a relatively good control of the spacer width. A good control of the spacer width is important, since the spacer width determines the separation of the memory cells' source/drain regions from the channel regions. This is an parameter, influencing the voltages to be applied to the source/drain regions of the memory cells, because when a source/drain region acts as a drain of the memory cell, the depletion region associated thereto must extend at least to the edge of the channel region.

In the previous description, reference has always been made to the formation of an array of memory cells of the contactless type. Albeit the advantages of these structure, this is not to be intended as a limitation of the invention, which can be applied to the fabrication of memory cell arrays of different structure.

Although the present invention has been disclosed and described by way of some embodiments, it is apparent to those skilled in the art that several modifications to the described embodiments, as well as other embodiments of the present invention are possible without departing from the scope thereof as defined in the appended claims.

## Claims

1. A process for fabricating a two-bit ROM cell, comprising:
forming a control electrode (**1052n**,**1053n**) over a semiconductor layer (**103**) of a first conductivity type, a region of the semiconductor layer underlying the control electrode constituting a memory cell channel region;
providing, on either side of the channel region, differentiated-resistance doped regions (**1151**-**1154**:**2011-2014,2031**-**2034**) having respective resistance values that depends on a logic state of a respective one of the two bits to be stored in the cell, the resistance values of the differentiated-resistance doped regions being set by means of a selective introduction of dopants,
**characterised in that** said providing the differentiated-resistance doped regions comprises:
selectively providing sidewall spacers (**109**) at sidewalls of the control electrode, and
using the sidewall spacers as a mask against the introduction of dopants.

2. The process according to claim 1, in which said selectively providing the sidewall spacers comprises forming the sidewall spacers at both the sidewalls of the control electrode, and selectively removing (**1131**,**1132**) none, either one or both of the sidewall spacers depending on a respective logic state of the two bits to be stored in the cell.

3. The process according to claim 2, further comprising forming in the semiconductor layer a first and a second source/drain regions (**1111**-**1115**) of a second conductivity type at the sides of the control electrode, the differentiated-resistance doped regions being interposed between the source/drain regions being and the channel region.

4. The process according to claim 3, in which the source/drain regions are formed in self-alignment with the spacers.

5. The process according to claim 4, in which the dopants are of the second conductivity type, and the sidewall spacers are removed to form relatively low-resistance doped regions (**1151**-**1154**) of the second conductivity type electrically connecting the respective adjacent source/drain region to an inversion channel that forms in the channel region under when the control electrode is biased in prescribed conditions.

6. The process according to claim 4, further comprising:
before forming the sidewall spacers, forming doped regions (**2011**-**2015**) of the second conductivity type at either side of and in self-alignment with the control electrode, and
after having selectively removed the sidewall spacers, introducing dopants of the first conductivity type for increasing a resistivity or reverting a conductivity type of a portion of the doped regions of the second conductivity type interposed between the respective adjacent source/drain region and the channel region.

7. The process according to any one of claims 2 to 6, further comprising:
before forming the sidewall spacers, forming on the control electrode a protective layer (**301**).
